# EUROPEAN PATENT SPECIFICATION

(11) **EP 4 128 378 B1**
(45) Date of publication and mention of the grant of the patent: **26.02.2025**
(21) Application number: 21716710.5
(22) Date of filing: 01.04.2021
(51) Int. Cl.: H10N 30/85, H10N 30/092

(54) **LEAD-FREE THREE-COMPONENT PIEZOELECTRIC POLYMER COMPOSITE AND CORRESPONDING FABRICATION METHOD**
BLEIFREIER PIEZOELEKTRISCHER DREIKOMPONENTEN-POLYMERVERBUNDSTOFF UND ENTSPRECHENDES HERSTELLUNGSVERFAHREN
COMPOSITE POLYMÈRE PIÉZOÉLECTRIQUE SANS PLOMB À TROIS COMPOSANTS ET PROCÉDÉ DE FABRICATION CORRESPONDANT

(30) Priority: 02.04.2020 IN 202041014651
(43) Date of publication of application: 08.02.2023
(73) Proprietor: SABIC Global Technologies B.V., 4612 PX Bergen op Zoom (NL)
(72) Inventor: GUHATHAKURTA, Soma, Bangalore 562125 Karnataka (IN); HOEKS LAMBERTUS, Theodorus, Bangalore 562125 Karnataka (IN); GANAPATHY BHOTLA VENKATA, Ramanarayanan, Bangalore 562125 Karnataka (IN); OWENS, Donald, Bangalore 562125 Karnataka (IN); MUCHUKUNTE BADARINATH,, Pallavi, Bangalore 562125 Karnataka (IN)
(74) Representative: IPecunia
(86) International application number: PCT/EP2021/058671
(87) International publication number: WO 2021/198448

(56) References cited:
- WO-A1-2019/180586
- CN-A- 109 575 572
- SALAEH SUBHAN ET AL: "Dynamically cured poly(vinylidene fluoride)/epoxidized natural rubber blends filled with ferroelectric ceramic barium titanate", COMPOSITES PART A, ELSEVIER, AMSTERDAM, NL, vol. 93, 22 November 2016 (2016-11-22), pages 107 - 116, XP029875651, ISSN: 1359-835X, DOI: 10.1016/J.COMPOSITESA.2016.11.024

## Description

### CROSS REFERENCE TO RELATED APPLICATIONS

None.

### FIELD OF INVENTION

The present invention generally relates to piezoelectric materials. More specifically, the present invention relates to polymeric materials with piezoelectric characteristics.

### BACKGROUND OF THE INVENTION

Piezoelectric materials are materials that have a defined relationship between electric charge accumulated in the material and mechanical stress applied to the material. Some conventional piezoelectric materials are inorganic ceramic materials (e.g., piezoelectric ceramic materials) which are heavy and brittle. These inorganic ceramic materials require high temperature processing exceeding 500°C. Other conventional piezoelectric materials are piezoelectric polymers, such as PVDF and PVDF-TrFE copolymers. , These piezoelectric polymers have a low piezoelectric charge/strain constant, d, compared to the piezoelectric ceramics. Piezoelectric charge/strain constant, d, is an important parameter to assess the actuation ability of a piezoelectric material when subjected to an electric field and piezoelectric voltage constant, g, is used to measure the sensing capability of a piezoelectric material. Inorganic piezoelectric ceramics exhibit high d (d₃₃ > 150 pC/N), but the high value of dielectric constant limits their g value (g₃₃ < 50mV.m/N). In contrast piezoelectric polymers show a lower d (d₃₃ ≈ 13-28pC/N) and a higher g (g₃₃ ≈ 200 mV-m/N). The d₃₃ value refers to induced polarization in direction 3 (parallel to the direction in which the ceramic element is polarized) per unit stress applied in direction 3. The g₃₃ value refers to induced electric field in direction 3 (parallel to the direction in which the ceramic element is polarized) per unit stress applied in direction 3. Materials exhibiting higher d₃₃ and g₃₃ values are desired. For a material to be considered as piezoelectric the d₃₃ value is greater than approximately 1 pC/N. An example of prior art may be found in the document "Dynamically cured poly(vinylidene fluoride)/epoxidized natural rubber blends filled with ferroelectric ceramic barium titanate" by Subhan Salaeh et al, 2016-11-22, Composites Part A, vol. 93, pages 107 - 116, which discloses ceramic-polymer composites based on dynamically cured blends of poly(vinylidene fluoride) and epoxidized natural rubber (PVDF/ENR TPVs) with barium titanate (BT) filler.

### BRIEF SUMMARY OF THE INVENTION

High performing piezoelectric materials are desirable for sensors, actuators, and energy harvesters in healthcare and biomedical applications and wearable electronics. For these and other applications, mechanically-flexible piezoelectric materials are desired. Embodiments of the invention provide piezoelectric composite films made using lead-free piezoelectric ceramic filler. Piezoelectric polymer composites provide one or more of a high piezoelectric property with mechanical flexibility, thin film forming ability, both free-standing film and supported film on a substrate, simple process of making the piezoelectric polymer composite, and/or low-temperature processing. The invention is defined by the independent claims 1 and 7.

An example polymer composite includes a polymer matrix of at least two polymers, with a piezoelectric ceramic filler embedded in the polymer matrix. The polymer matrix may include a fluorinated polymer and a second polymer having a dielectric constant of less than approximately 20. The second polymer characteristics affects the dielectric constant of the matrix and influences the dispersion of filler in the matrix, which in turn can affect the dielectric constant of the piezoelectric polymer composite. In addition to the dielectric constant being less than twenty, the second polymer is compatible with the first polymer. Compatibility of polymers may be determined based on a shift in the transition temperature (Tₘ or T_{g}) of polymers in the blend compared to that in the neat polymer. A polymer may be compatible when the shift is greater than 2°C. Example polymer materials for use as the second polymer in the polymer matrix that are compatible with PVDF-TrFE-CFE (when PVDF-TrFE-CFE is the fluorinated polymer) include PVDF-TrFE (which has a dielectric constant of between approximately 8-10), PC (which has a dielectric constant of between approximately 3), and PPO (which has a dielectric constant of approximately 2.5), each of which have a dielectric constant of less than 20. In some embodiments, piezoelectric ceramic filler loading in the polymer matrix may be between approximately 40-70% by volume. Piezoelectric ceramic filler loading outside of this range for PVDF-TrFE-CFE-based polymer matrices is mechanically brittle. In some embodiments, second polymer loading in the polymer matrix may be between 5-20% by weight. Second polymer loading outside of this weight range for PVDF-TrFE-CFE-based polymer matrices showed a drop in piezoelectric properties.

Manufacturing of piezoelectric polymer composites according to aspects of the disclosed invention may include dissolving the two polymers of the polymer matrix in a solvent to form a two-polymer solution, adding the piezoelectric ceramic filler to the two-polymer solution to form a suspension, and forming the polymer composite as a thin film by casting onto the substrate and drying the solvent. During processing, the piezoelectric polymer composite may be subjected to electric polarization. In some embodiments, the composite film is annealed and/or the composite film is subjected to a corona poling process. Additionally, in some embodiments, melt processing techniques may be used for making piezocomposite film; the piezocomposite film may be ordered as a (0-3) (random), (1-3) (structured) piezocomposite; and/or other ex-situ and in-situ techniques may be used for making the piezocomposites. (0-3) piezoelectric polymer composite refers to the connectivity of the ceramic and polymer components. The first digit corresponds to the connectivity in ceramic components, and the second digit corresponds to the connectivity in polymer. Composites in which the piezoelectric ceramic particles are surrounded by a three dimensionally connected polymer phase have (0-3) connectivity. Some (1-3) piezocomposite materials may exhibit higher d₃₃ values compared to (0-3) piezocomposite.

Polymer composites according to aspects of the disclosed invention may be deposited on substrates as thin film and formed into piezoelectric devices. In some embodiments, the polymer composite is a mechanically-flexible thin film formed on a flexible substrate as part of the manufacture of flexible electronic devices. An elongation-at-break value (in percent) may be used to demonstrate mechanical flexibility of materials. In some embodiments, the elongation-at-break (in percent) of the piezoelectric composite film is greater than 25%. Such electronic devices may include a piezoelectric sensor configured to generate an analog signal proportional to an amount of deflection applied to the piezoelectric sensor by a user. The piezoelectric sensor could be integrated in a mobile device for receiving user input for controlling the mobile device. In one example of a wearable medical device, the mechanical vibrations of body organs, such as a heartbeat, can be converted into electrical signals and transmitted via Bluetooth, Wi-Fi, or other signal to a smartphone or other computing device. In another example use of a piezoelectric material, the material may be used as a transducer to convert signals for output, such as by configuring the piezoelectric as a speaker or buzzer to convert signals to audible sounds. In yet another example use of a piezoelectric material, the material may be transparent and incorporated into an electronic display to create a touch-screen device that can display information to a user and receive user feedback on the displayed information through taps on the screen.

One example piezoelectric material according to some embodiments of the disclosure incudes a three-component piezoelectric composite material comprising polymer1/polymer2/piezoelectric filler, in which polymer1 is PVDF-TrFE-CFE, in which polymer2 is a low-dielectric polymer (having a dielectric constant < 20) that is compatible with PVDF-TrFE-CFE, and in which the piezoelectric filler is barium titanate. This example material, and other materials according to the invention, may be made using a solvent with dielectric constant > 20 and boiling point ≥ 80°C, in which the use of the solvent may provide the combination of high d₃₃ and g₃₃ of the piezocomposite films. A high boiling point and high dielectric solvent may help in filler dispersion within the matrix to improve piezoelectric characteristics of the film. In the composite, the piezoelectric filler loading may be greater than 40% by volume. Desirably high d₃₃ and g₃₃ values for formed piezocomposite films may be d₃₃ ≈ 30-70 pC/N and g₃₃ ≈ 100-300 mV-m/N. Another example piezoelectric material according to some embodiments of the disclosure include a three-component piezoelectric composite material comprising polymer1/polymer2/piezoelectric filler, in which polymer1 is PVDF-TrFE-CFE, in which polymer2 is a low-dielectric polymer (having a dielectric constant < 20) that is compatible with PVDF-TrFE-CFE, and in which the piezoelectric filler is lithium doped potassium sodium niobate (KNLN).

Piezocomposite materials according to embodiments of the invention, and devices incorporating those piezocomposite materials, may provide a cost benefit over commercial piezoelectric polymers. Further, lead-free piezocomposites are solution processible and cheaper in comparison with commercial piezoelectric polymers. Additionally, a self- standing piezoelectric polymer film of larger dimension can be made by manufacturing processes described herein. Further, piezocomposite films described herein can be made mechanically flexible, because the process is capable of forming a piezoelectric layer of desired thickness at a low temperature of about 110 degrees Celsius, or not exceeding 150 degrees Celsius. Piezoelectric composites can be deposited onto a substrate in some disclosed manufacturing techniques and poled more efficiently than contact poling. In some embodiments, depending on the application requirement, the desired metal electrode patterning can be carried out on top of the active layer after poling.

Example materials for the piezoelectric filler include any lead-free ceramic or single crystal material. Non-limiting examples of piezoelectric materials include inorganic compounds of the perovskite family. Non-limiting examples of piezoelectric ceramics with the perovskite structure include barium titanate (BaTiO₃), hydroxyapatite, apatite, lithium sulfate monohydrate, sodium potassium niobate, sodium bismuth titanate, quartz, organic materials (for example, tartaric acid, poly(vinylidene difluoride) fibers), or combinations thereof. In a preferred embodiment, the piezoelectric additive is BaTiO₃. The lead-free piezoelectric particles can have a particle size of 200 nm to 1000 nm, or 250 nm to 350 nm, or at least, equal to, or between any two of 200 nm, 225 nm, 250 nm, 275 nm, 300 nm, 325 nm, 350 nm, 375 nm, 400 nm, 425 nm, 450 nm, 475 nm, 500 nm, 525 nm, 550 nm, 575 nm, 600 nm, 625 nm, 650 nm, 675 nm, 700 nm, 725 nm, 750 nm, 775 nm, 800 nm, 825 nm, 850 nm, 875 nm, 900 nm, 925 nm, 950 nm, 975 nm, and 1000 nm.

Example materials for the polymers include a thermoset polymer, copolymer and/or monomer, a thermoplastic polymer, copolymer and/or monomer or a thermoset/thermoplastic polymer or copolymer blend. Thermoset polymers are malleable prior to heating and capable of forming a mold. The matrix can be made from a composition having a thermoplastic polymer and can also include other non-thermoplastic polymers, additives, and the like, that can be added to the composition. Thermoset polymeric matrices are cured or become crosslinked and tend to lose the ability to become pliable or moldable at raised temperatures. Non-limiting examples of thermoset polymers used to make the polymer film include epoxy resins, epoxy vinylesters, alkyds, amino-based polymers (e.g., polyurethanes, urea-formaldehyde), diallyl phthalate, phenolics polymers, polyesters, unsaturated polyester resins, dicyclopentadiene, polyimides, silicon polymers, cyanate esters of polycyanurates, thermosetting polyacrylic resins, bakelite, Duroplast, benzoxazines, or co-polymers thereof, or blends thereof.

Thermoplastic polymeric matrices have the ability to become pliable or moldable above a specific temperature and solidify below the temperature. The polymeric matrix of the composites can include thermoplastic or thermoset polymers, co-polymers thereof, and blends thereof that are discussed throughout the present application. Non-limiting examples of thermoplastic polymers include polyvinylidene fluoride (PVDF), PVDF-based polymer, PVDF copolymer (Polyvinylidene fluoride-trifluoroethylene (PVDF-TrFE)), PVDF terpolymer (poly(vinylidene fluoride-trifluoroethylene-chlorofluoroethylene) (PVDF-TrFE-CFE), poly(vinylidene fluoride-trifluoroethylene-chlorotrifluoroethylene) (PVDF-TrFE-CTFE), odd-numbered nylon, cyano-polymer, polyethylene terephthalate (PET), a polycarbonate (PC) family of polymers, polybutylene terephthalate (PBT), poly(1,4-cyclohexylidene cyclohexane-1,4-dicarboxylate) (PCCD), glycol modified polycyclohexyl terephthalate (PCTG), poly(phenylene oxide) (PPO), polypropylene (PP), polyethylene (PE), polyvinyl chloride (PVC), polystyrene (PS), polymethyl methacrylate (PMMA), polyethyleneimine or polyetherimide (PEI) and their derivatives, thermoplastic elastomer (TPE), terephthalic acid (TPA) elastomers, poly(cyclohexanedimethylene terephthalate) (PCT), polyethylene naphthalate (PEN), polyamide (PA), polysulfone sulfonate (PSS), sulfonates of polysulfones, polyether ether ketone (PEEK), polyether ketone (PEKK), acrylonitrile butyldiene styrene (ABS), acrylonitrile-styrene-acrylate (ASA) polymer, polyphenylene sulfide (PPS), co-polymers thereof, or blends thereof. In addition to these, other thermoplastic polymers known to those of skill in the art, and those hereinafter developed, can also be used in the context of the present invention. The thermoplastic polymer can be included in a composition that includes said polymer and additives. Non-limiting examples of additives include coupling agents, antioxidants, heat stabilizers, flow modifiers, colorants, *etc.,* or any combinations thereof. In a preferred instance, a polyvinylidene difluoride (PVDF) polymer, a copolymer thereof, or a terpolymer thereof is used. The terpolymer can be poly(vinylidene fluoride-trifluoroethylene-chlorofluoroethylene) (PVDF-TrFE-CFE).

Example solvents for use in the production of the lead-free piezoelectric composite can be any solvent having dielectric constant ≥ 20 and boiling point ≥ 80 °C. Non-limiting examples of solvents include dimethyl acetamide (DMAc), dimethyl formamide (DMF), dimethylsulfoxide (DMSO), N-methyl-2-pyrrolidone (NMP), or combinations thereof. In some embodiments, the solvent is DMAc. The dielectric constant of the solvent can be at least, equal to, or greater than 20, 25, 30, 35, 40, 45, 50, 55, 60, 65, 70, 75, 80. The boiling point of the solvent can be at least, equal to, or greater than 80 °C, 85 °C, 90 °C, 95 °C, 100 °C, 105 °C, 110 °C, 115 °C, 120 °C, 125 °C, 130 °C, 135 °C, 140 °C, 145 °C, 150 °C, 155 °C, 160 °C, 165 °C, 170 °C, 180 °C, 185 °C, 190 °C, 195 °C, 200 °C, or 210 °C. Various combinations of dielectric constant and boiling point can be used as long as both criteria are met.

The terms "wt.%", "vol.%" or "mol.%" refers to a weight, volume, or molar percentage of a component, respectively, based on the total weight, the total volume, or the total moles of material that includes the component. In a non-limiting example, 10 moles of component in 100 moles of the material is 10 mol.% of component.

The term "substantially" and its variations are defined to include ranges within 10%, within 5%, within 1%, or within 0.5%.

The terms "inhibiting" or "reducing" or "preventing" or "avoiding" or any variation of these terms, when used in the claims and/or the specification, includes any measurable decrease or complete inhibition to achieve a desired result.

The term "effective," as that term is used in the specification and/or claims, means adequate to accomplish a desired, expected, or intended result.

The use of the words "a" or "an" when used in conjunction with the term "comprising," "including," "containing," or "having" in the claims or the specification may mean "one," but it is also consistent with the meaning of "one or more," "at least one," and "one or more than one."

The words "comprising" (and any form of comprising, such as "comprise" and "comprises"), "having" (and any form of having, such as "have" and "has"), "including" (and any form of including, such as "includes" and "include") or "containing" (and any form of containing, such as "contains" and "contain") are inclusive or open-ended and do not exclude additional, unrecited elements or method steps.

The process of the present invention can "comprise," "consist essentially of," or "consist of" particular ingredients, components, compositions, etc., disclosed throughout the specification.

Other objects, features and advantages of the present invention will become apparent from the following figures, detailed description, and examples. It should be understood, however, that the figures, detailed description, and examples, while indicating specific embodiments of the invention, are given by way of illustration only and are not meant to be limiting. Additionally, it is contemplated that changes and modifications within the scope of the invention will become apparent to those skilled in the art from this detailed description. In further embodiments, features from specific embodiments may be combined with features from other embodiments. For example, features from one embodiment may be combined with features from any of the other embodiments. In further embodiments, additional features may be added to the specific embodiments described herein.

### BRIEF DESCRIPTION OF THE DRAWINGS

For a more complete understanding, reference is now made to the following descriptions taken in conjunction with the accompanying drawings, in which:
FIG. 1 shows a method of manufacturing a piezoelectric polymer composite according to some embodiments of the disclosure.
FIG. 2 shows DSC thermograms for the blends of PVDF-TrFE-CFE with each of the example second polymers as well as for neat PVDF-TrFE-CFE according to some embodiments of the disclosure.
FIGS. 3A-D shows scanning electron microscopy micrographs of top (FIG. 3A & FIG. 3C) and bottom (FIG. 3B and FIG. 3D) surfaces of a three-component piezoelectric polymer composite with 10 weight %PPO in the matrix with films in FIGS. 3A-B prepared with MEK solvent and films in FIGS. 3C-D prepared using DMAc solvent according to some embodiments of the disclosure.
FIG. 4 shows graphs for dielectric constant as a function of frequency for PVDF-TrFE-CFE/BT, and three component piezoelectric polymer composite having 60 volume percent BT loading and with 10 weight% second polymer in the matrix, PVDF, PVDF-TrFE, PC, PPO, with composites are prepared using DMAc according to some embodiments of the disclosure.
FIG. 5 shows graphs for dielectric constant as a function of frequency of piezoelectric polymer composites with and without PPO in the matrix for composites prepared using MEK according to some embodiments of the disclosure.
FIG 6. shows graphs for dielectric constant as a function of frequency for three-component piezoelectric polymer composite prepared using MEK and DMAc according to some embodiments of the disclosure.

### DETAILED DESCRIPTION OF THE INVENTION

A polymer composite exhibiting piezoelectric properties can be formed for film, sheet, or coating applications, in which the polymer composite includes a polymer matrix and a piezoelectric ceramic filler embedded in the polymer matrix. Although film examples are described in certain embodiments, the materials described may be used or adapted for sheets or coatings. The polymer matrix may include at least two polymers: a first polymer and a second polymer. The first polymer may be a fluorinated polymer, and the second polymer may be compatible with the first polymer and have a dielectric constant of less than approximately 20. The piezoelectric ceramic filler may be a lead-free ceramic filler, such as barium titanate, and be approximately 40-70% by volume of the polymer composite.

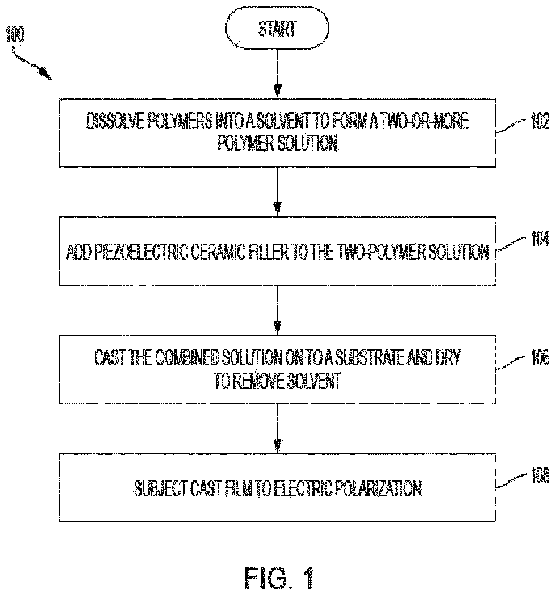

A method of manufacturing a piezoelectric polymer composite is shown in FIG. 1. The method 100 begins at block 102 with dissolving the two polymers in a solvent to form a two-polymer solution, which may form a two-polymer solution having a concentration of polymer to solvent of at least approximately 12%, such as formed by means 12g PVDF-TrFE-CFE resin dissolved in 100 mL solvent. The polymer concentration in the solution used for making piezocomposites may be 5-20% (wt/v), or more preferably 8-15%, or more preferably 10-13% (wt/v). A composite with less than 5% (wt/v) may result in a non-continuous film. Concentrations above 20% (wt/v) may result in difficulty creating high filler loading. In some embodiments, less than 5% (wt/v) may be possible with different manufacturing techniques to still obtain desirable piezoelectric and other properties. Then, at block 104, the method 100 continues with optionally adding the piezoelectric ceramic filler to the two-polymer solution to form a dispersion. In some embodiments, such as a polymer blend manufactured as a piezoelectric material will not include piezoelectric ceramic filler. At block 106, the polymer composite thin film may be formed by casting on a substrate and drying the solvent. At block 108, the cast piezocomposite film is subjected to an electric polarization. The method 100 may be performed without exceeding a temperature of about 120 degrees C, such that the manufacturing process can be used for the manufacturing of the piezoelectric composites on flexible substrates. The temperature may be selected as approximately the Curie temperature of the barium titanate piezoelectric ceramic filler and approximately the melting temperature of the PVDF-TrFE-CFE polymer matrix. In some embodiments, after casting the film on the substrate, the piezoelectric composite is annealed in an inert atmosphere (such as nitrogen gas). Although embodiments of the present invention have been described with reference to blocks of FIG. 1, it should be appreciated that operation of the present invention is not limited to the particular blocks and/or the particular order of the blocks illustrated in FIG. 1. Accordingly, embodiments of the invention may provide functionality as described herein using various blocks in a sequence different than that of FIG. 1.

Several piezoelectric composite films based on the semi-crystalline terpolymer, Poly(vinylidene fluoride-triflouroethylene-chloroflouroethylene), PVDF-TrFE-CFE, as a first polymer in the polymer matrix were prepared and characterized as described below. Four different polymers were tested as the second polymer to prepare three-component piezoelectric composite compositions. The example material compositions for piezoelectric composite films according to different embodiments of the invention are shown in Table 1.

For collection of the data in Table 1, The second polymer was dissolved in the solvent followed by PVDF-TrFE-CFE resin powder. The concentration of the solution was approximately 12% (wt/vol). The desired amount of barium titanate (BT) was then added slowly under stirring at 200 -250 rpm using a magnetic stirrer. After stirring for 30 minutes, the mixture was casted into a thin film using doctor blade on to a substrate, followed by drying in open air. The drying time was adjusted depending on the solvent used for making the composites. After drying, the films were peeled off from the glass plate and annealed under nitrogen. The composition of the polymer composite prepared following the procedure mentioned above and the solvent used for making the composites are provided in Table 1.

**Table 1. Piezoelectric polymer composite compositions (e.g., films or coatings) using PVDF-TrFE-CFE as the first polymer in the polymer matrix.**

| **Example no.** | **Polymer 2** | **Polymer 2 weight(%)** | **Solvent used for solution casting** | **Barium titanate loading (vol%)** |
|---|---|---|---|---|
| 1 | PVDF | 10 | DMAc | 60 |
| 2 | PVDF-TrFE | 10 | DMAc | 60 |
| 3 | PC | 10 | DMAc | 60 |
| 4 | PPO | 5 | DMAc | 60 |
| 5 | PPO | 10 | DMAc | 60 |
| 6 | PPO | 20 | DMAc | 60 |
| 7 | PPO | 10 | MEK | 40 |
| 8 | PPO | 10 | DMAc | 40 |

Table 2 describes the aspects of the second polymers used in the polymer matrix according to some embodiments of the invention. In each of these samples, the second polymers has a dielectric constant of less than 20.

**Table 2. Physical properties of sample second polymers for the polymer matrix.**

| **Polymer 2** | **Dielectric constant** | **Melting temperature (°C)** | **Glass transition temperature (°C)** |
|---|---|---|---|
| PVDF | 8-12 | 169.5 | - |
| PVDF-TrFE | 9-12 | 151 | - |
| PC | ~3 | - | 151 |
| PPO | 2-3 | - | 135 |

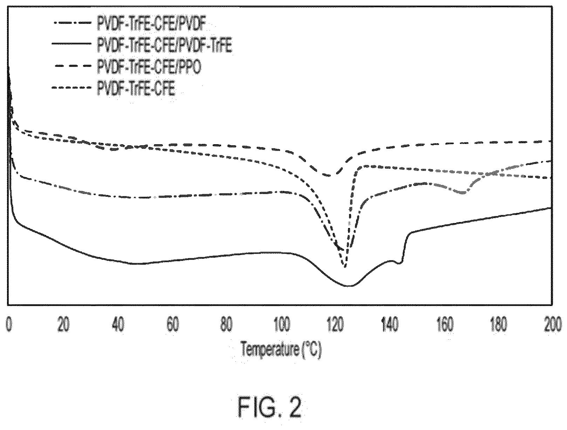

The assessment of compatibility for these second polymers with PVDF-TrFE-CFE is determined based on the shift of the melting temperature of the second polymer when in the blend with PVDF-TrFE-CFE compared to the melting temperature of the neat polymers. FIG. 2 shows DSC thermograms for the blends of PVDF-TrFE-CFE with each of the example second polymers as well as for neat PVDF-TrFE-CFE according to some embodiments of the disclosure. As shown in FIG. 2, in blends, the melting transition of PVDF-TrFE and PVDF are 142 (ΔTₘ ~9°C) and 168.5°C (ΔTₘ ~1°C), respectively. Unlike PVDF and PVDF-TrFE, PPO is completely amorphous polymer, and PVDF-TrFE-CFE is semi-crystalline, the melting peak in DSC thermogram only arise from PVDF-TrFE-CFE. The melting point of PVDF-TrFE-CFE in the blend with PPO is broadened as compared to that in the neat terpolymer, and the enthalpy of fusion is reduced to 11 J/g from 17 J/g. The compatibilities for PVDF, PVDF-TrFE, and PPO with PVDF-TrFE-CFE based on these criteria are incompatible, partially compatible, and compatible, respectively.

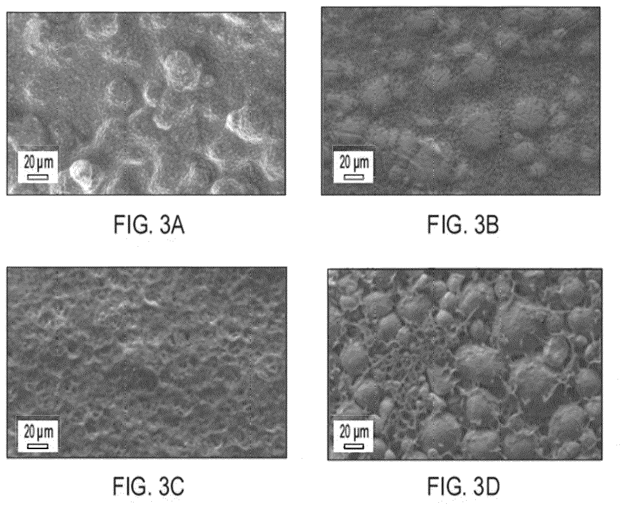

Two different solvents, MEK and DMAc having dielectric constant of 18.5 and 47 and boiling point of 80 and 189°C respectively, were chosen to fabricate the piezoelectric polymer composite films. FIGS. 3A-D shows scanning electron microscopy micrographs of top (FIG. 3A & FIG. 3C) and bottom (FIG. 3B and FIG. 3D) surfaces of a three-component piezoelectric polymer composite with 10 weight %PPO in the matrix having PPO as polymer 2 and 40 volume percent barium titanate loading, fabricated using MEK and DMAc with films in FIGS. 3A-B prepared usingMEK solvent and films in FIGS. 3C-D prepared using DMAc solvent according to some embodiments of the disclosure. As seen in SEM micrographs, the barium titanate particles in composites form aggregates which are nearly spherical in shape. In Example 7, the filler particles protrude out from the film top surface due to the rapid evaporation of the low boiling solvent, MEK and towards the bottom, polymers form an insulating layer over the filler particles. In Example 8, depressions are seen at the top surface, which appears due to the settling down of the high-density filler particles before the evaporation of the high boiling solvent. Spherical interconnected filler particles are seen at the bottom surface, the polymer forms network structure. Solvents having different dielectric constants and boiling points impact the filler dispersion in the polymer composite. Table 3 shows the effect of different low dielectric polymers on piezoelectric strain constant, d₃₃ and piezoelectric voltage constant, g₃₃, and dielectric constant of piezoelectric polymer composite.

**Table 3. Effect of second polymer in polymer matrix on piezoelectric and dielectric properties of piezoelectric composite compositions (e.g., films or coatings).**

| **Example no.** | **d₃₃ (pC/N)** | **εᵣ** | **g₃₃ (mV.m/N)** |
|---|---|---|---|
| 1 | 49.2 | 57.2 | 97.1 |
| 2 | 41.9 | 47.1 | 100.4 |
| 3 | 42.2 | 22 | 216.7 |
| 4 | 2.7 | - | - |
| 5 | 37.5 | 15.9 | 231.7 |
| 6 | 6.1 | - | - |
| 7 | 19.3 | 69.6 | 31.4 |
| 8 | 24 | 14.7 | 184 |
| PVDF-TrFE-CFE/BT(60) | 50 | 55.1 | 102.5 |

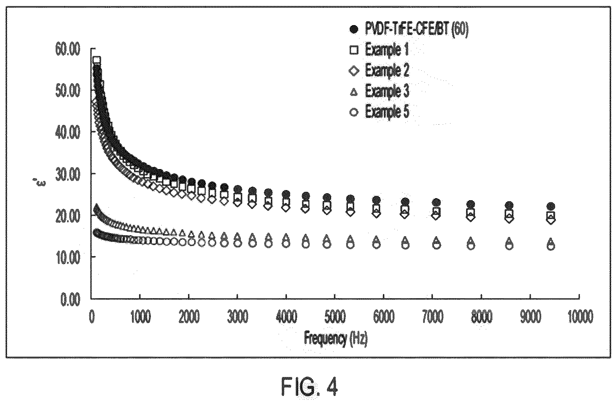

A comparison of the PVDF-TrFE-CFE/PVDF-based piezoelectric composite and a composite with only PVDF-TrFE-CFE as polymer matrix shows that effect of PVDF on d₃₃ and εᵣ in not significant (as shown in Table 3 and FIG. 4) because PVDF is incompatible with PVDF-TrFE-CFE. FIG. 4 shows graphs for dielectric constant as a function of frequency for PVDF-TrFE-CFE/BT, and three component piezoelectric polymer composite having 60 volume percent BT loading and with 10 weight% second polymer in the matrix, PVDF, PVDF-TrFE, PC, PPO, with composites are prepared using DMAc according to some embodiments of the disclosure.

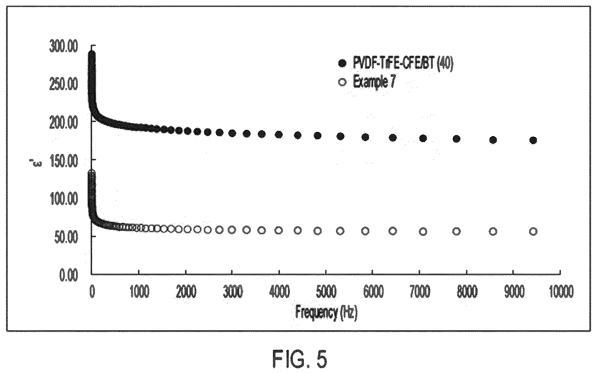

A comparison of the other example polymer matrices (PVDF-TrFE-CFE/PVDF-TrFE, PVDF-TrFE-CFE/PC and PVDF-TrFE-CFE/PPO) and a film with only PVDF-TrFE-CFE as polymer matrix shows PVDF-TrFE, PC and PPO as second polymer result in a reduction of d₃₃ and εᵣ (as shown in FIG. 4). This conclusion is further supported by the piezoelectric polymer composites having 40 volume percent barium titanate loading, fabricated using MEK as solvent, as shown in FIG. 5. FIG. 5 shows graphs for dielectric constant as a function of frequency of piezoelectric polymer composites with and without PPO in the matrix for composites prepared using MEK according to some embodiments of the disclosure. The effect of PPO as the second polymer of the polymer matrix, may be significant as compared to a composite having PVDF-TrFE-CFE as polymer matrix. The reduction of d₃₃ and εᵣ can be attributed to the compatibility between PVDF-TrFE-CFE and second polymers with a low dielectric constant below approximately 20.

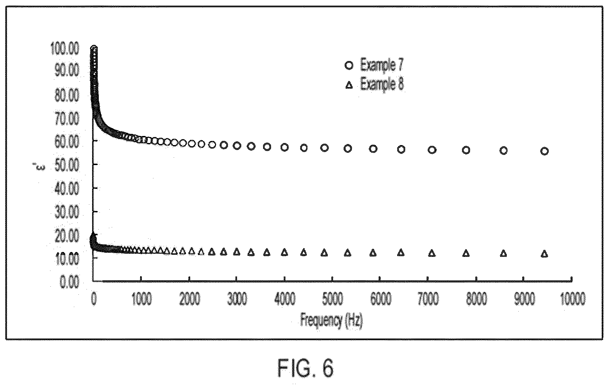

FIG. 6 shows the effect of two different solvents on the dielectric constant of three-component piezocomposite according to some embodiments of the disclosure. Comparison of example 7 and 8 prepared using MEK and DMAc, respectively, reveals that high boiling solvent having high dielectric constant can reduce the dielectric constant of the composite significantly as compared to low boiling solvent having low dielectric constant. A lower dielectric constant of the polymer composite results in an improvement of g₃₃. PVDF-TrFE, PC and PPO are only three example second polymers with dielectric constants below 20, compatible with PVDF-TrFE-CFE. Other polymers may be compatible with PVDF-TrFE-CFE and used in a polymer matrix of a piezoelectric composite film to achieve the desired piezoelectric characteristics. Additionally, another polymer, other than PVDF-TrFE-CFE may be used as the first polymer, and second polymers with dielectric constants below 20 compatible with that first polymer. Additionally, although each of the example films has a 90%/10% ratio of first polymer to second polymer, other ratios may be used to obtain different characteristics in the piezoelectric composite film.

When forming the piezoelectric composite, the solvent used to combine the first and second polymer should have a dielectric constant greater than 20 and a boiling point ≥ 80°C in order to achieve desirable d₃₃ and g₃₃ values and desired mechanical characteristics. In some embodiments, the boiling point can be significantly higher than 1000 degrees Celsius, such as around 1800 degrees Celsius or more, while having a dielectric constant of greater than 20. Although solvent mixing process is described herein for manufacturing the example piezoelectric composite films, other manufacturing processes may be used such as standard melt mixing to create these same blends with desirable piezoelectric characteristics.

An example solvent mixing process for the lead-free three-component PVDF-TrFE-CFE-based piezoelectric composite material begins with dissolving the second polymer in a solvent. The second polymer as described above should be selected to be compatible with PVDF-TrFE-CFE and have a dielectric constant of less than 20. The solvent as described above should be selected to have a dielectric constant greater than 20 and a boiling point ≥ 80°C. The first polymer, PVDF-TrFE-CFE, is then added and stirred until dissolved completely. In the embodiments described above, the concentration of the solution was approximately 12% (w/v). Then, barium titanate (BT) was added slowly to the solution while stirring. After stirring for approximately 30-45 mins duration to ensure approximately complete mixing, the mixture was cast into a thin film using a doctor blade on to a substrate and dried in open air. After drying, the films were peeled off from the substrate and annealed under nitrogen.

The piezoelectric composite can be made using solution casting or forming methodology. A solution of a polymer can be obtained. The solution can include a solvent and polymer. The solution can include at least, equal to, or between any two of 1.5 wt./vol%, 5 wt./vol%, 10 wt./vol%, 15 wt./vol%, and 20 wt./vol% of the polymer. In some embodiments, the solution includes and 10 wt.% to 12 wt.% PVDF or PVDF-TRFE-CFE or a blend thereof. In some embodiments, no compatibility improvers are used to make the lead-free polymeric composites of the present invention.

The piezoelectric additive can be dispersed or suspended in the polymer solution. The piezoelectric additive can be a plurality (e.g., 2 or more, suitably 5 or more, 10 or more, 50 or more, 100 or more, 500 or more, 1000 or more, etc.) of lead-free piezoelectric particles. The lead-free piezoelectric particles can be dispersed in the solution via any suitable method, including mixing, stirring, folding or otherwise integrating the lead-free piezoelectric particles in the matrix so as to generate a uniform dispersion or suspension of the particles in the matrix. In some embodiments, the solution is added to the piezoelectric additive.

The dispersion or suspension can be subjected to conditions suitable to form the piezoelectric composite of the present invention. The following description references dispersion, but it also applies to a suspension. In one embodiment, the dispersion includes PVDF, PVDF-TRFE, or PVDF-TRFE-CFE or a blend thereof, and barium titanate. In some embodiments, the dispersion can be shaped or cast. Shaped or shaping, or casting can include a mechanical or physical processes to change to a desired form. Shaping can also include simply placing a dispersion into a desired container or receptacle, thereby providing it with a maintained shape or form. It should be noted that the shaped form is not necessarily the final form, as additional processing (e.g., machining, forming, etc.) can be completed on the final, cured composite. The act of shaping the dispersion for use in the methods described herein is primarily to give some initial structure to the dispersion prior to further processing. A rigid or specific shape is not required.

Casting can be pouring the dispersion on a casting surface. Non-limiting examples of casting include air casting (e.g., the dispersion passes under a series of air flow ducts that control the evaporation of the solvents in a particular set period of time such as 24 to 48 hours), solvent or emersion casting, (e.g., the dispersion is spread onto a moving belt and run through a bath or liquid in which the liquid within the bath exchanges with the solvent). The spreading of the dispersion on the casting surface can be done with a doctor blade, rolling spreader bar or any of several configurations of flat sheeting extrusion dies.

During casting or shaping, the solvent can be removed thereby leaving the dispersion on the substrate or in the mold. Heat can be applied to assist the removal of the solvent. By way of example, the shaped material can be heated at a temperature of at least, equal to, or between any two of 50 °C, 55 °C, 60 °C, 65 °C, 70 °C, 75 °C, and 80 °C. The resulting shaped polymer composite material can be annealed at a temperature of at least, equal to, or between any two of 80 °C, 85 °C, 90 °C, 95 °C, 100 °C, 105 °C, 110 °C, 115 °C, and 120 °C for a desired amount of time (e.g., 5, 10, 15, 20, 25 hours or any range or value there between). The shaped material can be a film, a sheet or the like. Some or all of the solvent can be removed during the heating process. For example, heating and/or annealing the lead-free piezoelectric polymer precursor composite material can remove at least, equal to, or between any two of 50, 55, 60, 65, 70, 75, 80, 85, 90, 95, and 100 wt.% of the solvent.

After annealing the shaped polymer composite material can be subjected to conditions to induce electric polarization in the lead-free piezoelectric additive (e.g., plurality of particles) in the polymeric composite material. During electric polarization, the piezoelectric particles can be connected to one another in a linear or semi-linear manner (e.g., chains of particles). Columns of piezoelectric particles are suitably formed by the stacking or aligning of more than one chain. In a non-limiting example, the shaped polymer composite material can be poled. By way of example, the polymer composite material can be poled with a selected electric field at room temperature (e.g., after cooling of the composite), or at a selected electric field at a selected temperature, at least one of the selected electric field and the selected temperature being chosen in accordance with a desired dipole orientation, a desired polarization strength, or property of the article of manufacture.

The temperature for performing poling can be in accordance with a desired dipole orientation and/or a desired polarization strength, or in accordance with a desired stress state of a finished actuator. For example, the poling can be performed at a selected cooling temperature range, through a selected heating temperature, or through a selected heating temperature heating and cooling temperature range. In some instance, the poling may occur over a "range" (e.g., selected range) of temperatures rather than at a specific constant temperature. In some embodiments, poling can be performed at a temperature of at least, equal to, or between any two of 80 °C, 85 °C, 90 °C, 95 °C, 100 °C, 105 °C, 110 °C, 115 °C, and 120 °C. The applied voltage level parameter for the poling can be selected in various ways. For example, the applied voltage level parameter can be selected as constant, or changing (e.g., ramped) over a period of time. In some embodiments, poling is performed using corona discharge using an electrode gap of 0.5 to 1.5 cm, or about 1 cm for a desired amount of time (e.g., about 1 hour).

For electrical measurements involving the samples described above, circular gold electrodes were deposited on both sides of the composite films. The dielectric constant and loss tangent were measured at room temperature in a frequency range of 100 Hz - 1 MHz. The cast piezocomposite films were subjected to corona poling to test piezoelectric response. Corona poling of the piezocomposites was carried out under the conditions detailed below; the needles were kept at high voltage (typically 10 kV), at a poling temperature of 110°C, with an electrode gap of 1 cm, and with a poling time of 1 hour. The poled films were maintained at room temperature for 48 hours, and then the piezoelectric strain constant (d₃₃) of the poled films was measured at ambient temperature at a frequency of 110 Hz with a clamping force of 10N and an oscillatory force 0.25N to obtain the values described above in Table 3.

The piezoelectric composite can include a polymer and a lead-free piezoelectric additive. The piezoelectric composite can include at least, equal to, or between any two of 1, 10, 20, 30, 40, 45, 50, 55, 60, 65, 70, 75, 80, 85, 90, 95, and 99 wt.% polymer matrix. The amount of lead-free piezoelectric additive present in the polymer matrix can be at least, equal to, or between any two of 15, 20, 25, 30, 35, 40, 45, 50, 55, 60, and 65 vol.%. In some embodiments, the piezoelectric composite includes PVDF-TRFE-CFE and 20 vol.% to 60 vol.% barium titanate particles having an average particle size of 250 to 350 nm. In some embodiments, the piezoelectric composite includes, consists of, or consists essentially of PVDF-TRFE-CFE and 20 vol.% to 60 vol.% barium titanate particles having an average particle size of 250 to 350 nm. In some embodiments, the piezoelectric composite can have less than 0.1 wt.% of solvent or between 0 and 0.1 wt.% solvent.

In some embodiments, the piezoelectric composite can have any shape or form. In some embodiments, the piezoelectric composite is a film or sheet. In some embodiments, the film or sheet has a thickness dimension of 50 to 200 microns, or at least, equal to, or between any two of 50, 60, 70, 80, 90, 100, 110, 120, 130, 140, 150, 160, 170, 180, 190, and 200 microns.

Properties of the piezoelectric composite include electrical and mechanical properties. Non-limiting examples of electrical properties can include piezoelectric constant, dielectric constant, and the like. The d₃₃ of the piezoelectric composite be at least, equal to, or between 40 pC/N, 45 pC/N, 50 pC/N, 55 pC/N, 56 pC/N, 57 pC/N, 58 pC/N, 59 pC/N, 60 pC/N, 61 pC/N, 62 pC/N, 63 pC/N, 64 pC/N, 65 pC/N, 66 pC/N, 67 pC/N, 68 pC/N, 69 pC/N, and 70 pC/N. By way of example, the piezoelectric composite can have a dielectric constant that is less than, equal to, or between any two of 120, 115, 110, 105, 100, 95, 90, 85, 80, 75, 70, 65, 60, 55, 50, 45, 40, and 35. In some embodiments, the dielectric constant is from 90 to 210. The lead-free piezoelectric composite can have a storage modulus can range from 100 to 325 MPa, or at least, equal to, or between any two of 100, 125, 150, 175, 200, 225, 250, 275, 300, and 325 MPa. Storage modulus can be measured according to ISO 6721 at room temperature and a 1 Hz strain of 0.2%. The lead-free piezoelectric composite can have an elongation break of 30 to 500% under uniaxial loading at room temperature (e.g., 25 to 35 °C). Elongation break can be measured using standard dynamic mechanical analyzer.

Although embodiments of the present application and their advantages have been described in detail, it should be understood that various changes, substitutions and alterations can be made herein without departing from the scope of the embodiments as defined by the appended claims.

## Claims

1. A polymer composite, comprising:
a polymer matrix comprising at least two polymers: a first polymer comprising a fluorinated polymer; and a second polymer having a dielectric constant of less than 20 and the second polymer being compatible with the fluorinated polymer, in which the polymer matrix comprises 5-20 percent by weight or more of the second polymer; and
a lead-free piezoelectric ceramic filler embedded in the polymer matrix, in which the piezoelectric ceramic filler comprises 40-70% by volume of the polymer composite.

2. The polymer composite of claim 1, in which the polymer composite exhibits piezoelectric properties.

3. The polymer composite of claim 1 or 2, in which the first polymer comprises PVDF-TrFE-CFE.

4. The polymer composite of any of claims 1-3, further comprising a flexible substrate attached to a thin film of the polymer composite, and in which the polymer composite thin film is a mechanically-flexible thin film.

5. The polymeric composite of any of claim 1-4, wherein the film or sheet has a thickness of 50-200 micrometers.

6. The polymer composites of any of claims 1-5, in which the polymer composite exhibiting piezoelectric properties has: a piezoelectric strain constant of between 30 and 70 pC/N; and a piezoelectric voltage constant between 100 and 300 mV.m/N.

7. A method of manufacturing a thin film using the polymer composite as claimed in claim 1 to 6.

8. The method of claim 7, in which the method comprises:
dissolving the first polymer into a solution of the second polymer in a solvent to form a two-polymer solution (102) wherein the solvent has a dielectric constant of at least 20 and a boiling point of at least 80 degrees C;
adding the piezoelectric ceramic filler to the two-polymer solution (104) to form a dispersion or suspension;
forming the polymer composite thin film by casting and drying the solvent (106); and
subjecting the polymer composite thin film to an electric polarization (108).

9. The method of claim 8, in which dissolving the first polymer into the solution of the second polymer produces the two-polymer solution comprising 5 to 20 wt/vol% of polymer, and preferably 10 wt/vol% to 12 wt/vol% of polymer.

10. The method of any of claims 7 to 9, further comprising annealing the polymer composite thin film in an inert atmosphere.

11. A piezoelectric sensor comprising a thin film of the polymer composite of any of claims 1 to 6, in which the piezoelectric sensor is configured to generate an analog signal proportional to an amount of deflection applied to the piezoelectric sensor by a user, in which the piezoelectric sensor is integrated in a mobile device.

## Patentansprüche

1. Polymerverbundstoff, umfassend:
eine Polymermatrix, umfassend mindestens zwei Polymere: ein erstes Polymer, umfassend ein fluoriertes Polymer; und ein zweites Polymer, das eine Dielektrizitätskonstante von weniger als 20 aufweist, wobei das zweite Polymer mit dem fluorierten Polymer kompatibel ist, wobei die Polymermatrix zu 5-20 Gewichtsprozent oder mehr das zweite Polymer umfasst; und
ein bleifreier piezoelektrischer Keramikfüller, eingebettet in die Polymermatrix, wobei der piezoelektrische Keramikfüller zu 40-70 Vol.-% den Polymerverbundstoff umfasst.

2. Polymerverbundstoff nach Anspruch 1, wobei der Polymerverbundstoff piezoelektrische Eigenschaften vorweist.

3. Polymerverbundstoff nach Anspruch 1 oder 2, wobei das erste Polymer PVDF-TrFE-CFE umfasst.

4. Polymerverbundstoff nach einem der Ansprüche 1 bis 3, ferner umfassend ein flexibles Substrat, das an einem Dünnfilm des Polymerverbundstoffs befestigt ist, und wobei der Polymerverbundstoffdünnfilm ein mechanisch flexibler Dünnfilm ist.

5. Polymerverbundstoff nach einem der Ansprüche 1 bis 4, wobei der Film oder die Folie eine Dicke von 50-200 Mikrometer aufweist.

6. Polymerverbundstoffe nach einem der Ansprüche 1 bis 5, wobei der Polymerverbundstoff, der piezoelektrische Eigenschaften vorweist, aufweist: eine piezoelektrische Dehnungskonstante zwischen 30 und 70 pC/N;
und eine piezoelektrische Spannungskonstante zwischen 100 und 300 mV.m/N.

7. Verfahren zum Herstellen eines Dünnfilms unter Verwendung des Polymerverbundstoffs nach den Ansprüchen 1 bis 6.

8. Verfahren nach Anspruch 7, wobei das Verfahren umfasst:
Auflösen des ersten Polymers in einer Lösung des zweiten Polymers in einem Lösungsmittel, um eine Zwei-Polymer-Lösung (102) auszubilden
wobei das Lösungsmittel eine Dielektrizitätskonstante von mindestens 20 und einen Siedepunkt von mindestens 80 Grad C aufweist;
Hinzufügen des piezoelektrischen Keramikfüllers zu der Zwei-Polymer-Lösung (104), um eine Dispersion oder Suspension auszubilden;
Ausbilden des Polymerverbundstoffdünnfilms durch ein Gießen und ein Trocknen des Lösungsmittels (106); und Unterziehen des Polymerverbundstoffdünnfilms einer elektrischen Polarisation (108).

9. Verfahren nach Anspruch 8, wobei das Auflösen des ersten Polymers in der Lösung des zweiten Polymers die Zwei-Polymer-Lösung produziert, umfassend zu 5 bis 20 Gew.Vol.-% Polymer und vorzugsweise zu 10 Gew.Vol.-% bis 12 Gew.Vol.-% Polymer.

10. Verfahren nach einem der Ansprüche 7 bis 9, ferner umfassend das Glühen des Polymerverbundstoffdünnfilms in einer inerten Atmosphäre.

11. Piezoelektrischer Sensor, umfassend einen Dünnfilm des Polymerverbundstoffs nach einem der Ansprüche 1 bis 6, wobei der piezoelektrische Sensor konfiguriert ist, um ein analoges Signal zu erzeugen, das proportional zu einer Menge von Auslenkung ist, die auf den piezoelektrischen Sensor durch einen Benutzer ausgeübt wird, wobei der piezoelektrische Sensor in eine mobile Vorrichtung integriert ist.

## Revendications

1. Composite polymère, comprenant :
une matrice polymère comprenant au moins deux polymères : un premier polymère comprenant un polymère fluoré ; et un second polymère ayant une constante diélectrique inférieure à 20 et le second polymère étant compatible avec le polymère fluoré, dans lequel la matrice polymère comprend 5 à 20 pour cent en poids ou plus du second polymère ; et
une charge céramique piézoélectrique sans plomb incorporée dans la matrice polymère, dans lequel la charge céramique piézoélectrique représente 40 à 70 % en volume du composite polymère.

2. Composite polymère selon la revendication 1, dans lequel le composite polymère présente des propriétés piézoélectriques.

3. Composite polymère selon la revendication 1 ou 2, dans lequel le premier polymère comprend du PVDF-TrFE-CFE.

4. Composite polymère selon l'une quelconque des revendications 1 à 3, comprenant en outre un substrat flexible fixé à un film mince du composite polymère, et dans lequel le film mince de composite polymère est un film mince mécaniquement flexible.

5. Composite polymère selon l'une quelconque des revendications 1 à 4, dans lequel le film ou la feuille a une épaisseur de 50 à 200 micromètres.

6. Composites polymères selon l'une quelconque des revendications 1 à 5, dans lesquels le composite polymère présentant des propriétés piézoélectriques a : une constante de déformation piézoélectrique comprise entre 30 et 70 pC/N ;
et une constante de tension piézoélectrique comprise entre 100 et 300 mV.m/N.

7. Procédé de fabrication d'un film mince à l'aide du composite polymère selon les revendications 1 à 6.

8. Procédé selon la revendication 7, dans lequel le procédé comprend :
la dissolution du premier polymère dans une solution du second polymère dans un solvant pour former une solution à deux polymères (102)
dans lequel le solvant a une constante diélectrique d'au moins 20 et un point d'ébullition d'au moins 80 degrés C ;
l'ajout de la charge céramique piézoélectrique à la solution à deux polymères (104) pour former une dispersion ou une suspension ;
la formation du film mince de composite polymère par coulée et séchage du solvant (106) ; et le fait de soumettre le film mince de composite polymère à une polarisation électrique (108).

9. Procédé selon la revendication 8, dans lequel la dissolution du premier polymère dans la solution du second polymère produit la solution à deux polymères comprenant de 5 à 20 % en poids/volume de polymère, et de préférence de 10 % en poids/volume à 12 % en poids/volume de polymère.

10. Procédé selon l'une quelconque des revendications 7 à 9, comprenant en outre le recuit du film mince de composite polymère dans une atmosphère inerte.

11. Capteur piézoélectrique comprenant un film mince du composite polymère selon l'une quelconque des revendications 1 à 6, dans lequel le capteur piézoélectrique est configuré pour générer un signal analogique proportionnel à une quantité de déviation appliquée au capteur piézoélectrique par un utilisateur, dans lequel le capteur piézoélectrique est intégré dans un appareil mobile.
